# EUROPEAN PATENT APPLICATION

(11) **EP 1 545 012 A1**
(43) Date of publication of application: **22.06.2005**
(21) Application number: 04024413.9
(22) Date of filing: 13.10.2004
(51) Int. Cl.: H03M 13/29

(54) **Three-dimensional error correction encoding method**

(30) Priority: 15.12.2003 KR 2003091378; 04.06.2004 KR 2004040778
(71) Applicant: Daewoo Electronics Corporation, Seoul (KR)
(72) Inventor: Hwang, Euiseok, Seoul (KR)
(74) Representative: Jacoby, Georg, Dr.

(57) **Abstract**

The present invention relates to an error correction encoding method using a three-dimensional Reed-Solomon code. In the error correction encoding method, pieces of input information are arranged in a three-dimensional data block. Three-dimensional error correction encoding is performed with respect to the three-dimensional data block, thereby adding horizontal, vertical and z-axial error correction parity symbols to the three-dimensional data block in horizontal, vertical and z-axial directions, respectively.

## Description

The present invention relates to a three-dimensional error correction encoding method; and more particularly, to a three-dimensional error correction encoding method, which performs error correction coding with respect to a three-dimensional data block using one-dimensional parity in digital information devices or communication devices, thereby improving error correction capability.

One parameter for determining the quality of a digital communication system is a "Bit Error Ratio (BER)". BER is the parameter for determining the probability of occurrence of bits having an error in the output of a reception system. Storage devices, such as tapes, discs, Compact Discs (CDs), Digital Versatile Discs (DVDs) and barcodes, mobile communication devices, such as cellular phones and microwave links, satellite communication devices, and digital televisions generally require BER of 10⁻⁹ or below.

In order to increase BER without increasing signal to noise ratio (SNR), error correction codes are used to encoded information. In this case, even though some errors occur during a transmission process, the errors can be corrected in a receiver. Error correction technologies that automatically correct a large number of errors capable of occurring during the transmission procedure are widely known. One of the technologies, a "Reed-Solomon error correction code" has been widely popularized.

As well known to those skilled in the art, the Reed-Solomon error correction code is adapted to encode digital data to be processed using error correction codes so as to reduce errors when the digital data, used in digital information devices or communication devices, are to be transmitted, to be recorded on the storage media or to be reproduced from storage media. The Reed-Solomon error correction code, proposed by Reed and Solomon, is a kind of error correction code capable of correcting group errors. In particular, damaged surfaces of magnetic tapes or discs or dust thereon may cause group errors to be generated, thus considerably requiring a Reed-Solomon (RS) code. An RS (204, 188) code indicates that, if input date is 188 bytes and an error correction code of 16 bytes is added to the input data and transmitted together with the input data, an error of 8 bytes is fully corrected. Further, with the excellent group error correction characteristics of the RS code, the RS code is combined with a convolution code so that excellent correction capability may be implemented for sporadic errors, thereby being used in terrestrial radio communication fields, wired communications and encryption communications. Therefore, the combined codes are used for space communication, satellite communication and satellite broadcasting that are in an environment where sporadic and group errors both occur, thus powerfully eliminating channel errors. Further, an RS code is widely applied to error correction for communication systems, such as mobile communication systems and spread spectrum systems, and storage media, such as computer memory devices, CDs and Digital Audio Tapes (DATs), and adopted as a transmission standard in Device Video Broadcast (DVB).

For such a RS error correction code, a two-dimensional RS error correction code is generally used, in which horizontal and vertical parity symbols for error correction are added to information symbols in horizontal and vertical directions, respectively. In this case, parity symbols are two-dimensionally added to information symbols and sequentially arranged, so that the two-dimensional RS error correction code exhibits excellent performance compared to the one-dimensional application of parity symbols. However, there is a problem in that, if a large number of errors exist, saturation occurs, so that error correction cannot be performed in any direction in two dimensions, thus losing repetitive correction capability, which is the best feature of the two-dimensional error correction.

Further, in the case where horizontal and vertical parity symbols are added, two-dimensional parity symbols, that is, vertical parity symbols corresponding to horizontal parity symbols, are added, so that parity information increases excessively, thus excessively increasing a code rate.

It is, therefore, an object of the present invention to provide a three-dimensional error correction encoding method, which performs three-dimensional error correction encoding with respect to a three-dimensional data block in horizontal, vertical and z-axial directions, thus improving error correction capability.

It is another object of the present invention to provide a three-dimensional error correction encoding method, which improves a code rate in addition to error correction capability while performing three-dimensional error correction encoding.

In accordance with the present invention, there is provided a three-dimensional error correction encoding method comprising the steps of:
a) arranging pieces of input information in a three-dimensional data block: and
b) performing three-dimensional error correction encoding with respect to the three-dimensional data block, thereby adding horizontal, vertical and z-axial error correction parity symbols to the three-dimensional data block in horizontal, vertical and z-axial directions, respectively.

The above and other objects and features of the present invention will become apparent from the following description of preferred embodiments given in conjunction with the accompanying drawings, in which:
FIG. 1 illustrates a conceptual view of code construction to show an error correction encoding method using a three-dimensional Reed-Solomon code according to a first embodiment of the present invention;
FIG. 2 illustrates a conceptual view of code construction to show an error correction encoding method using the three-dimensional Reed-Solomon code according to a second embodiment of the present invention;
FIG. 3 illustrates a conceptual view of code construction to show an error correction encoding method using the three-dimensional Reed-Solomon code according to a third embodiment of the present invention;
FIG. 4 illustrates a flowchart of the error correction encoding method using the three-dimensional Reed-Solomon code according to the third embodiment of the present invention; and
FIG. 5 illustrates a flowchart of an error correction decoding method using the three-dimensional Reed-Solomon code according to the third embodiment of the present invention.

Hereinafter, embodiments of the present invention will be described in detail with reference to the attached drawings.

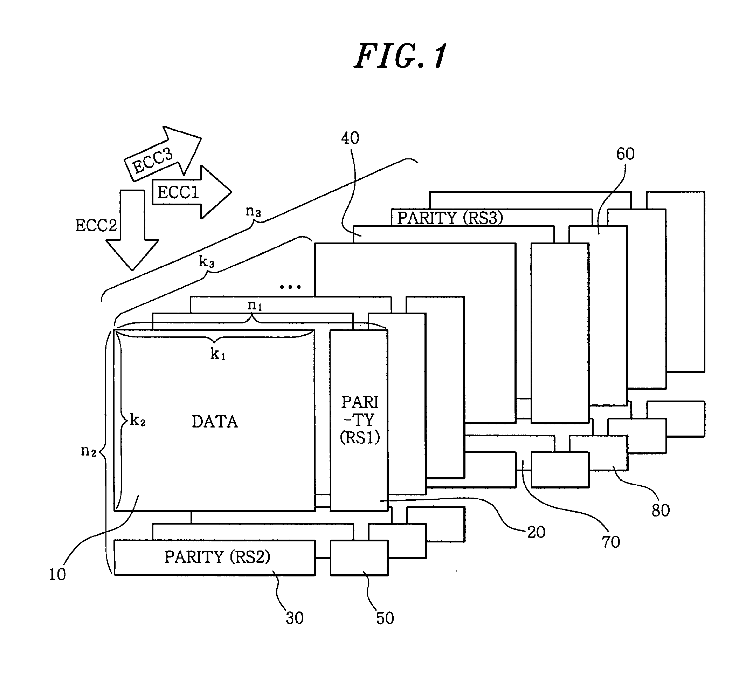

FIG. 1 illustrates a conceptual view of code construction to show an error correction encoding method using a three-dimensional (3D) Reed-Solomon code according to a first embodiment of the present invention. As shown in FIG. 1, pieces of input information are arranged in a 3D data block 10 implemented with a (k1, k2, k3) array of information symbols, where k1, k2 and k3 are positive integers. In other words, the 3D data block 10 has a (k1, k2, k3) array structure in which k1*k2*k3 information symbols are arranged along horizontal, vertical and z-axial directions.

3D error correction encoding is performed with respect to the 3D data block 10, so that horizontal, vertical and z-axial error correction parity symbols are added to the 3D data block 10 in horizontal, vertical and z-axial directions, respectively. In FIG. 1, the horizontal, vertical and z-axial directions are indicated by first, second and third error correction encoding axis ECC1, ECC2 and ECC3, respectively. First, n1-k1 error correction parity symbols are added to each of k2*k3 number of k1 information symbols in a horizontal direction, thereby constructing (n1-k1)*k2*k3 horizontal error correction parity symbols RS1 20. Thereafter, n2-k2 error correction parity symbols are added to each of n1*k3 number of k2 information symbols and/or parity symbols in a vertical direction, thereby constructing n1*(n2-k2)*k3 vertical error correction parity symbols RS2 30 and 50. Finally, n3-k3 error correction parity symbols are added to each of n1*n2 number of k3 information symbols and/or parity symbols in a z-axial direction, thereby constructing n1*n2* (n3-k3) z-axial error correction parity symbols RS3 40, 60, 70 and 80.

In order to perform 3D error correction encoding through the above-described method, pieces of input information should be arranged in a 3D data block implemented with a (k1, k2, k3) array of information symbols, and stored in a memory. With respect to the 3D data block 10 stored in the memory, n1-k1 primary horizontal error correction parity symbols are added to every k1 information symbols, so that (n1-k1)*k2*k3 primary horizontal error correction parity symbols 20, generated in this way, are stored in the memory. If the above procedure is repeated, the horizontal length of the 3D data block increases from k1 to n1.

Thereafter, with respect to the 3D data block 10 stored in the memory, n2-k2 primary vertical error correction parity symbols are added to every k2 information symbols in a vertical direction. Further, with respect to the (n1-k1)*k2*k3 primary horizontal error correction parity symbols 10, n2-k2 secondary vertical error correction parity symbols are added to every k2 error correction parity symbols in the vertical direction. Therefore, k1*(n2-k2)*k3 primary vertical error correction parity symbols 30 and (n1-k1)*(n2-k2)*k3 secondary vertical error correction parity symbols 50, which have been generated through the above procedure, are stored in the memory. If the above procedure is repeated, the vertical length of the 3D data block increases from k2 to n2.

Finally, with respect to the 3D data block 10 stored in the memory, n3-k3 primary z-axial error correction parity symbols are added to every k3 information symbols in a z-axial direction; with respect to both the (n1-k1)*k2*k3 primary horizontal error correction parity symbols 20 and the k1*(n2-k2)*k3 primary vertical error correction parity symbols 30, secondary z-axial error correction parity symbols are added to every k3 error correction parity symbols in the z-axial direction. Further, with respect to the (n1-k1)*(n2-k2)*k3 secondary vertical error correction parity symbols 50, tertiary z-axial error correction parity symbols are added to every k3 error correction parity symbols in the z-axial direction. Therefore, k1*k2*(n3-k3) primary z-axial error correction parity symbols 40, (n1-k1)*k2*(n3-k3) and k1* (n2-k2)*(n3-k3) secondary z-axial error correction parity symbols 60 and 70, and (n1-k1)*(n2-k2)*(n3-k3) tertiary z-axial error correction parity symbols 80, which have been generated through the above procedure, are stored in the memory. If the above procedure is repeated, the z-axial length of the 3D data block increases from k3 to n3.

The (k1, k2, k3) array of information symbols 10, (n1-k1)*k2*k3, k1*(n2-k2)*k3 and k1*k2*(n3-k3) primary error correction parity symbols 20, 30 and 40, (n1-k1)*(n2-k2)*k3, (n1-k1)*k2*(n3-k3) and k1*(n2-k2)*(n3-k3) secondary error correction parity symbols 50, 60 and 70, and (n1-k1)*(n2-k2)*(n3-k3) tertiary error correction parity symbols 80 are further encoded, if necessary, and, then, the encoding results thereof are stored in a storage medium (not shown), such as a holographic storage medium.

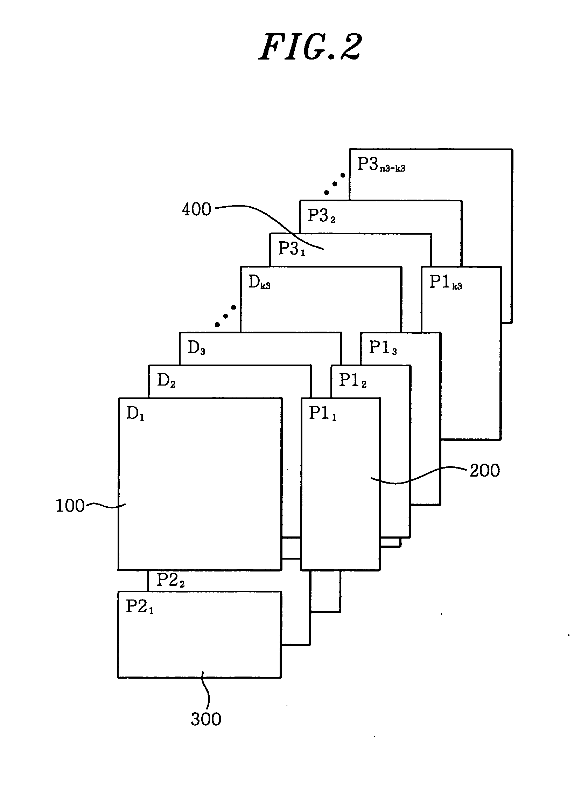

FIG. 2 illustrates a conceptual view of code construction to show an error correction encoding method using the 3D Reed-Solomon code according to a second embodiment of the present invention.

Unlike the 3D Reed-Solomon code according to the first embodiment, a 3D Reed-Solomon code according to the second embodiment performs only error correction encoding for a (k1, k2, k3) array of information symbols itself, thus including only primary error correction parity symbols and excluding secondary and tertiary error correction parity symbols. In detail, the 3D Reed-Solomon code according to the second embodiment includes (n1-k1)*k2*k3 primary horizontal error correction parity symbols P1₁ to P1ₖ₃ 200, k1*(n2-k2)*k3 primary vertical error correction parity symbols P2₁ to P2ₖ₃ 300, and k1*k2*(n3-k3) primary z-axial error correction parity symbols P3₁ to P3ₙ₃₋ₖ₃ 400, in addition to a (k1, k2, k3) array of information symbols D1 to Dₖ₃ 100. In the present invention, the error correction parity symbols are sequentially generated in the order of horizontal, vertical and z-axial directions. However, the present invention is not limited to this order of generation of error correction parity symbols. For example, horizontal, vertical and z-axial error correction parity symbols may be generated in an order differing from that of the second embodiment, and may be generated simultaneously rather than sequentially. According to the second embodiment of the present invention, the number of error correction parity symbols added is minimized, thus improving error correction capability while decreasing a code rate.

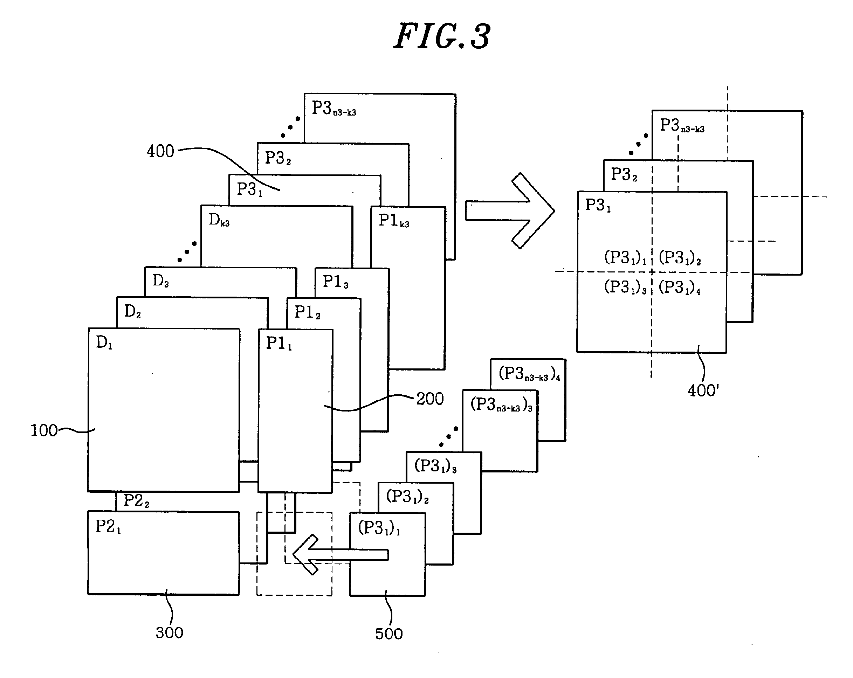

FIG. 3 illustrates a conceptual view of code construction to show an error correction encoding method using a 3D Reed-Solomon code according to a third embodiment of the present invention.

Unlike the 3D Reed-Solomon code according to the second embodiment, the 3D Reed-Solomon code according to the third embodiment is constructed in such a way that the primary error correction parity symbols generated according to the second embodiment are rearranged. For example, primary z-axial error correction parity symbols P3₁ to P3ₙ₃₋ₖ₃ 400 among (n1-k1)*k2*k3 primary horizontal error correction parity symbols P1₁ to P1ₖ₃ 200, k1*(n2-k2)*k3 primary vertical error correction parity symbols P2₁ to P2ₖ₃ 300, and k1*k2*(n3-k3) primary z-axial error correction parity symbols P3₁ to P3ₙ₃₋ₖ₃ 400 may be rearranged at the locations of the secondary vertical error correction parity symbols of the 3D Reed-Solomon code according to the second embodiment shown in FIG. 2. If necessary, as shown in FIG. 3, each area of the primary z-axial error correction parity symbols P3₁ to P3ₙ₃₋ₖ₃ 400 is equally divided into four parts, and then four-divided primary z-axial error correction parity symbols (P3₁)₁, (P3₁)₂, (P3₁)₃, (P3₁)₄, ..., (P3ₙ₃₋ₖ₃)₁, (P3ₙ₃₋ₖ₃)₂, (P3ₙ₃₋ₖ₃)₃, (P3ₙ₃₋ₖ₃)₄ 500 are generated, which may be rearranged sequentially at the locations of the secondary vertical error correction parity symbols. The rearrangement of the z-axial error correction parity symbols according to the present invention is only an embodiment, and the present invention is not limited to this embodiment. Therefore, all of the horizontal, vertical and z-axial error correction parity symbols as well as the horizontal and vertical error correction parity symbols can be rearranged.

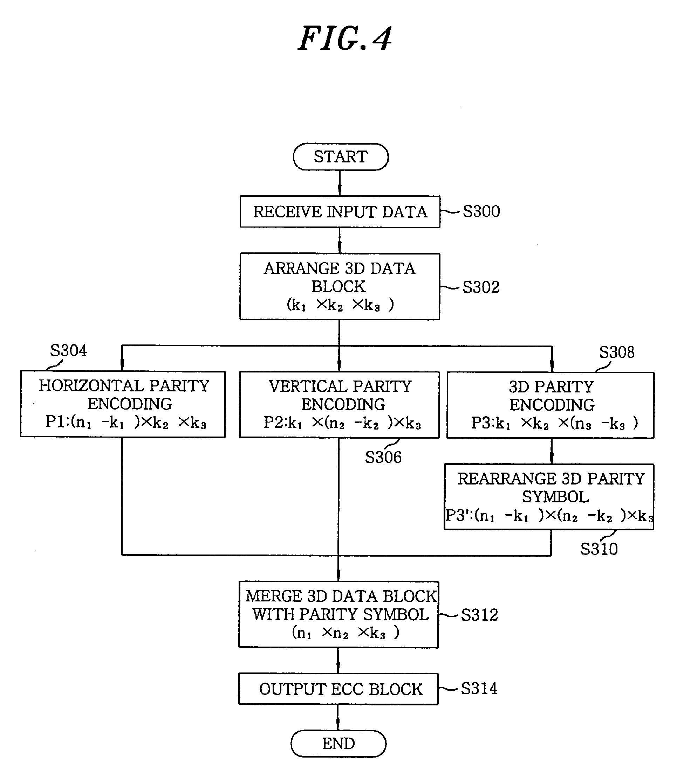

FIG. 4 illustrates a flowchart of the error correction encoding method using a 3D Reed-Solomon code according to the third embodiment of the present invention.

First, pieces of input information are received at step S300, and arranged in a 3D data block at step S302. The 3D data block is a (k1, k2, k3) array of information symbols, where k1, k2 and k3 are positive integers.

While steps S304, S306 and S308 are simultaneously performed, error correction encoding is performed in horizontal, vertical and z-axial directions with respect to the 3D data block, thereby constructing (n1-k1)*k2*k3 primary horizontal error correction parity symbols 200, k1*(n2-k2)*k3 primary vertical error correction parity symbols 300, and k1*k2*(n3-k3) primary z-axial error correction parity symbols 400, respectively. The primary z-axial error correction parity symbols 400 are divided by a preset area and rearranged at step S310. The rearranged primary z-axial error correction parity symbols 500 are arranged in the region corresponding to the secondary vertical error correction parity symbols shown in FIG. 2, that is, region where the imaginary extension of the primary horizontal error correction parity symbols 200 intersects the imaginary extension of the primary vertical error correction parity symbols 300. Therefore, the rearranged primary z-axial error correction parity symbols 500 preferably have a dimension of (n1-k1)*(n2-k2)*k3. In order to meet this dimension, it is possible to delete a part of z-axial error correction parity symbols if necessary, or, conversely, to add dummy parity symbols.

The 3D data block 100, the primary horizontal error correction parity block 200, the primary vertical error correction parity block 300 and the rearranged primary z-axial error correction parity block 500 are merged into a coding block at step S312, and the merged coding block is output as an Error Correction Code (ECC) block at step S314.

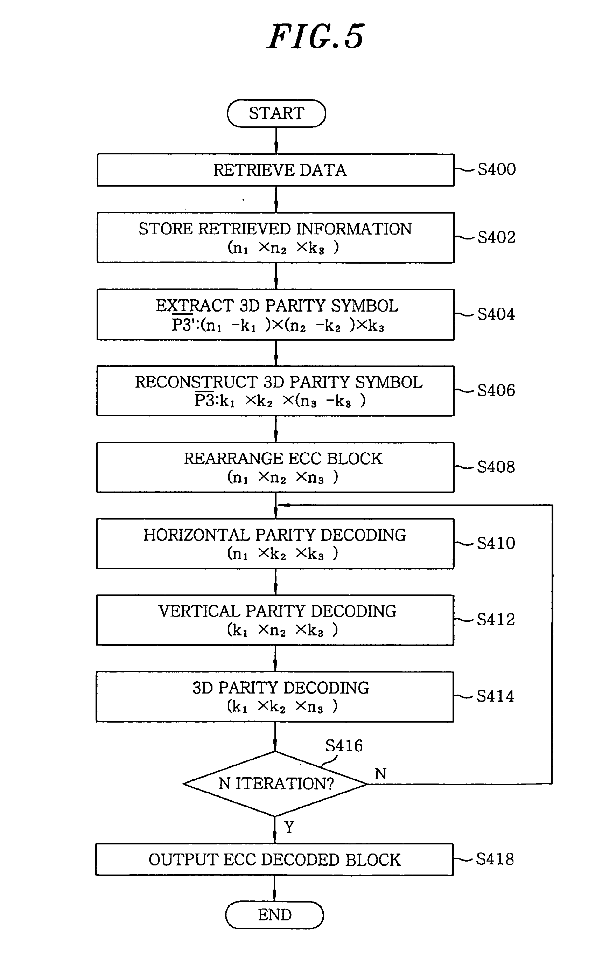

FIG. 5 illustrates a flowchart of an error correction decoding method using a 3D Reed-Solomon code according to the third embodiment of the present invention.

First, retrieved information, obtained by retrieving data from a storage medium (not shown), such as a holographic medium, is received at step S400. The retrieved information is stored in a decoding buffer in preset error correction encoding blocks, for example, n1*n2*k3 blocks, at step S402. The (n1-k1)*(n2-k2)*k3 rearranged z-axial error correction parity symbols are extracted from the error correction encoding blocks stored in the decoding buffer at step S404. The rearranged z-axial error correction parity symbols are arranged in reverse sequence to that of the encoding step, thereby reconstructing k1*k2*(n3-k3) z-axial error correction parity symbols at step S406. The reconstructed z-axial error correction parity symbols are connected in the z-axial direction of a decoding block, thereby constructing a (n1, n2, n3) rearranged error correction encoding block in which error correction parity symbols are added along horizontal, vertical and z-axial directions at step S408.

Error correction decoding is sequentially or simultaneously performed with respect to the above-described horizontal error correction parity symbols 200, the vertical error correction parity symbols 300 and the z-axial error correction parity symbols 400 at steps S410, S412 and S414. It is determined whether a certain number n of error correction decoding iterations has been performed at step S416. After a certain number n of error correction decoding iterations, error correction decoded results are output in the form of an error correction decoded block at step S418. The number of error correction decoding iterations can be determined according to the number of parity symbols of the error correction codes, and the noise detection level of a corresponding channel.

While the invention has been shown and described with respect to the preferred embodiments, it will be understood by those skilled in the art that various changes and modifications may be made without departing from the scope of the invention as defined in the following claims.

## Claims

1. A three-dimensional error correction encoding method comprising the steps of:
a) arranging pieces of input information in a three-dimensional data block; and
b) performing three-dimensional error correction encoding with respect to the three-dimensional data block, thereby adding horizontal, vertical and z-axial error correction parity symbols to the three-dimensional data block in horizontal, vertical and z-axial directions, respectively.

2. The three-dimensional error correction encoding method of claim 1, wherein the three-dimensional data block is a (k1, k2, k3) array of information symbols, k1, k2 and k3 being positive integers, and
the step b) includes the steps of:
b1) adding n1-k1 error correction parity symbols to each of k2*k3 number of k1 information symbols of the three-dimensional data block in the horizontal direction, thereby constructing (n1-k1) *k2*k3 horizontal error correction parity symbols for k1*k2*k3 information symbols;
b2) adding n2-k2 error correction parity symbols to each of k1*k3 number of k2 information symbols of the three-dimensional data block in the vertical direction, thereby constructing k1*(n2-k2)*k3 vertical error correction parity symbols for k1*k2*k3 information symbols; and
b3) adding n3-k3 error correction parity symbols to each of k1*k2 number of k3 information symbols of the three-dimensional data block in the z-axial direction, thereby constructing k1*k2*(n3-k3) z-axial error correction parity symbols for k1*k2*k3 information symbols.

3. The three-dimensional error correction encoding method of claim 2, further comprising the step of c) rearranging the horizontal, vertical and z-axial error correction parity symbols, after the step b3).

4. The three-dimensional error correction encoding method of claim 1, wherein the three-dimensional data block is a (k1, k2, k3) array of information symbols, k1, k2 and k3 being positive integers, and
the step b) includes the steps of:
b4) adding n1-k1 error correction parity symbols to each of k2*k3 number of k1 information symbols of the three-dimensional data block in the horizontal direction, thereby constructing (n1-k1)*k2*k3 horizontal error correction parity symbols for k1*k2*k3 information symbols;
b5) adding n2-k2 error correction parity symbols to each of k1*k3 number of k2 information symbols of the three-dimensional data block and each of (n1-k1)*k3 number of k2 horizontal error correction parity symbols in the vertical direction, thereby constructing n1*(n2-k2)*k3 vertical error correction parity symbols for k1*k2*k3 information symbols and (n1-k1)*k2*k3 horizontal error correction parity symbols; and
b6) adding n3-k3 error correction parity symbols to each of k1*k2 number of k3 information symbols of the three-dimensional data block, each of (n1-k1)*k2 number of k3 horizontal error correction parity symbols and each of n1*(n2-k2) and (n1-k1)*(n2-k2) number of k3 vertical error correction parity symbols in the z-axial direction, thereby constructing n1*n2*(n3-k3) z-axial error correction parity symbols for k1*k2*k3 information symbols, (n1-k1)*k2*k3 horizontal error correction parity symbols and n1*(n2-k2)*k3 and (n1-k1)* (n2-k2)*k3 vertical error correction parity symbols.

5. The three-dimensional error correction encoding method of claim 1, wherein the horizontal, vertical and z-axial error correction parity symbols are formed using a Reed-Solomon code.
